# EUROPEAN PATENT APPLICATION

(11) **EP 4 776 841 A1**
(43) Date of publication of application: **15.07.2026**
(21) Application number: 25218345.4
(22) Date of filing: 25.11.2025
(51) Int. Cl.: H10W 90/10, H10W 70/60, H10W 90/26, H10W 90/20, H10W 90/00

(54) **PACKAGE WITH SPACED INTERPOSERS AND BRIDGING INTERPOSERS**

(30) Priority: 05.12.2024 US 202463728530 P; 21.05.2025 US 202519214933
(71) Applicant: Samsung Electronics Co., Ltd., Suwon-si, Gyeonggi-do 16677 (KR)
(72) Inventor: KANG, Dae Hyun, San Jose, CA, 95134 (US); NGUYEN, Phu Cuong, San Jose, CA, 95134 (US); RADHAKRISHNAN, Satish, San Jose, CA, 95134 (US); JEONG, Hyoun Kwon, San Jose, CA, 95134 (US); JEONG, Soogil, San Jose, CA, 95134 (US); KIM, Chang Jun, San Jose, CA, 95134 (US); KIM, Jaehyup, San Jose, CA, 95134 (US); PARK, Joung Won, San Jose, CA, 95134 (US); CHATTERJEE, Kamalika, San Jose, CA, 95134 (US)
(74) Representative: Kuhnen & Wacker Patent- und Rechtsanwaltsbüro PartG mbB

(57) **Abstract**

A system-on-a-chip, SoC, includes segmented interposers and computer chips, such as high-bandwidth memory, HBM, devices. One computer chip is on each segmented interposer. The SoC also includes second interposers connecting the segmented interposers together. At least some of the second interposers extend across a gap between adjacent segmented interposers. The SoC also includes an organic substrate coupled to each of the segmented interposers.

## Description

### BACKGROUND

### 1. Field

The present disclosure relates to segmented silicon interposers for three-dimensional (3D) chips.

### 2. Description of the Related Art

Interposers are thin substrates utilized in semiconductors and integrated circuits to connect two or more chips or dies. Interposers are typically connected via micro-bump bonding and provide a highspeed communication interface allowing the chips to communicate with each other. Interposers may provide signal routing, power distribution, and thermal management. Additionally, interposers are commonly utilized in 2.5D chip packaging in which multiple dies are stacked horizontally on the interposer and 3D chip packaging in which the interposers connect multiple dies vertically.

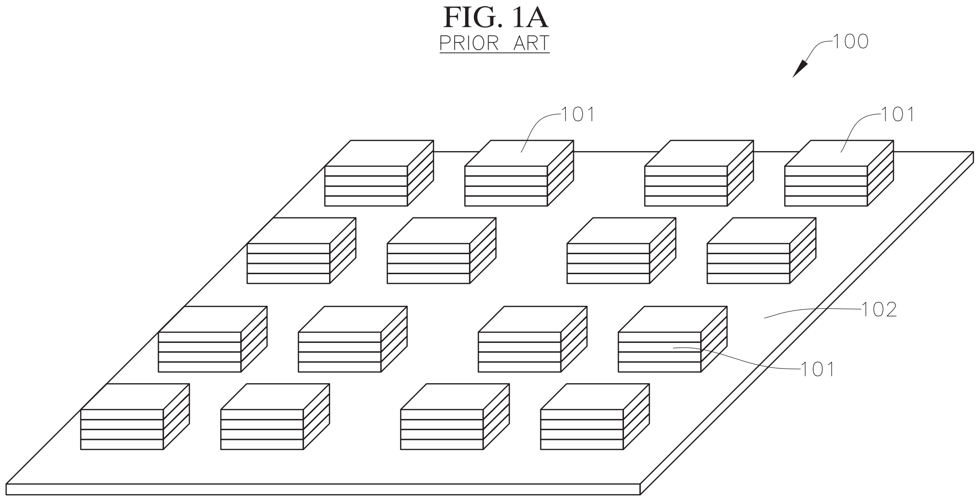

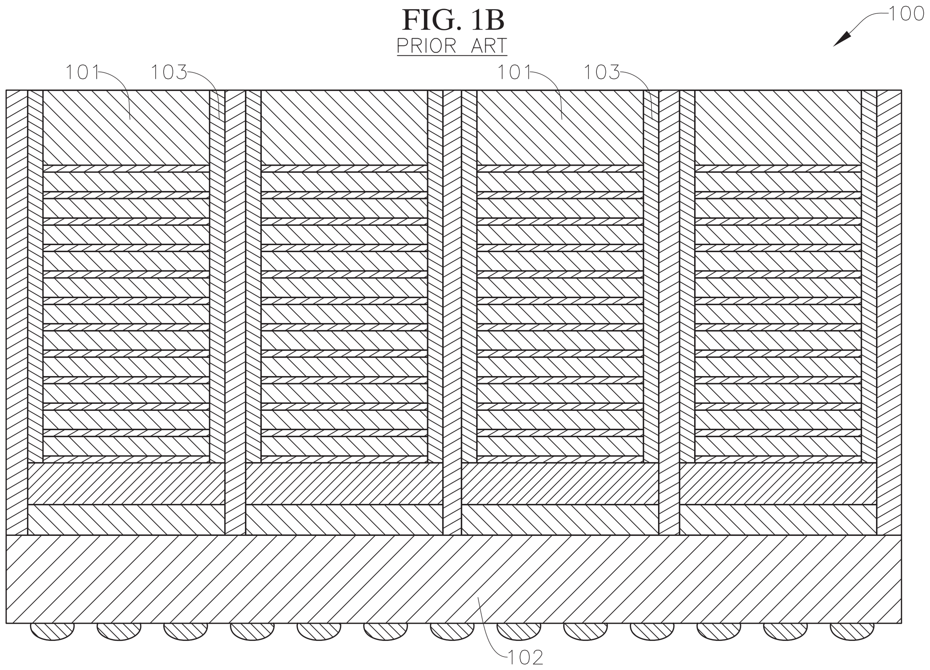

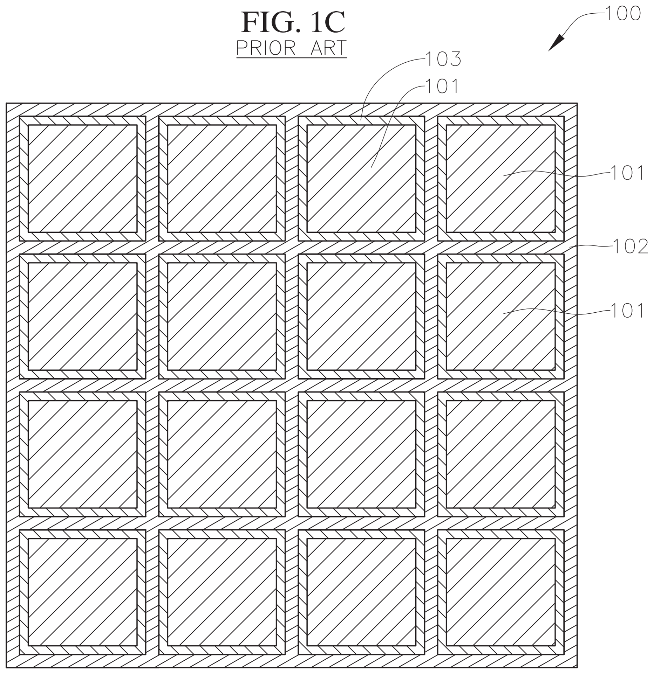

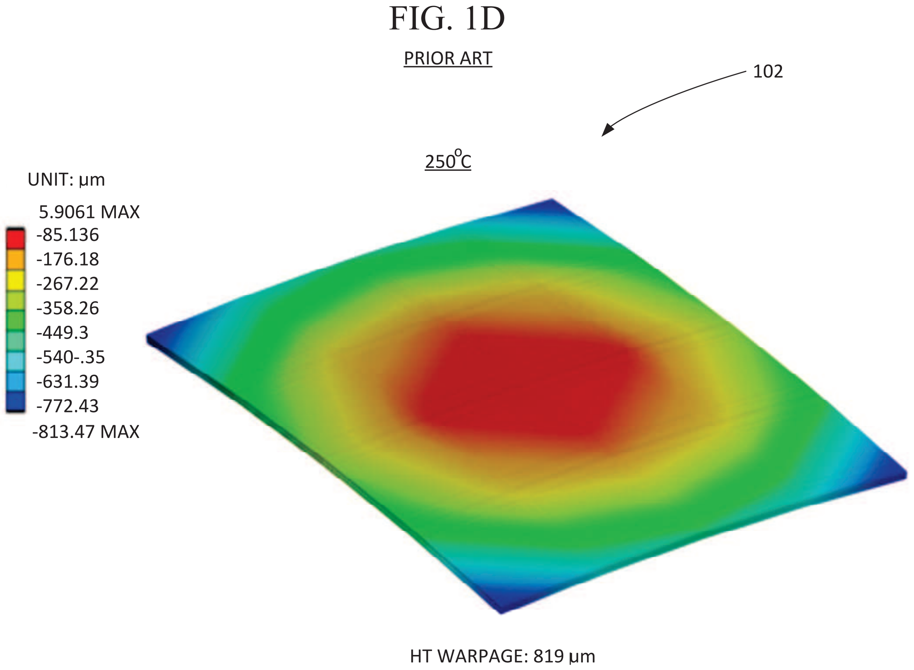

However, related art interposers are sized to accommodate multiple dies and are prone to extensive warpage due to the different coefficients of thermal expansion (CTE) between the different dies on the interposer. For instance, FIGS. 1A-1C depict a related art device **100** including sixteen high-bandwidth memory (HBM) devices **101** arranged in a 4x4 grid on a single silicon interposer **102.** Additionally, as shown in FIGS. 1A-1C, an epoxy molding compound (EMC) layer **103** is provided on each of the HBM devices **101** to increase heat dissipation. The related art interposer **102** depicted in FIGS. 1A-1B has a size of approximately 52 mm x 68 mm and a thickness of approximately 160 µm. As illustrated in FIG. 1D, the related art interposer **102** exhibits a maximum warpage of approximately 819 µm at a temperature of approximately 250 °C. This extensive warpage of the related art interposer **102** may make assembly impossible (or at least difficult) and/or may result in a lower manufacturing yield.

The above information disclosed in this Background section is only for enhancement of understanding of the background of the invention and therefore it may contain information that does not constitute prior art.

### OBJECTIVE OF THE DISCLOSURE

The object of the present disclosure is to provide segmented silicon interposers for three-dimensional stacked chips with improved performance.

### SUMMARY

The present disclosure relates to various embodiments of a system-on-a-chip (SoC). In one embodiment, the SoC includes segmented interposers and computer chips. One computer chip is on each segmented interposer. The SoC also includes second interposers connecting the segmented interposers together. At least some of the second interposers extend across a gap between adjacent segmented interposers. The SoC also includes an organic substrate coupled to each of the segmented interposers.

The second interposers may be between the segmented interposers and the organic substrate.

The second interposers may be coupled to lower surfaces of the segmented interposers with micro-bumps.

The second interposers may be coupled to an upper surface of the organic substrate with micro-bumps.

The second interposers may be coupled to an upper surface of the organic substrate with controlled-collapse chip connection (C4) bumps.

The second interposers may be on upper surfaces of the segmented interposers.

The second interposers may have a height substantially equal to a height of the computer chips.

The second interposers may be coupled to upper surfaces of the segmented interposers with micro-bumps.

Some of the second interposers may not extend across the gap between adjacent segmented interposers.

The computer chips may be high-bandwidth memory (HBM) devices.

The present disclosure also relates to various embodiments of a method of manufacturing a system-on-a-chip (SoC). In one embodiment, the method includes coupling computer chips to segmented interposers such that one computer chip is on each segmented interposer. The method also includes coupling the segmented interposers together with second interposers and coupling the segmented interposers to an organic substrate.

Coupling the segmented interposers together with the second interposers comprises may include bonding the second interposers to lower surfaces of the segmented interposers with micro-bumps.

Coupling the segmented interposers together with the second interposers may include bonding the second interposers to upper surfaces of the segmented interposers with micro-bumps.

Coupling the segmented interposers to the organic substrate may include bonding the segmented interposers directly to an upper surface of the organic substate with controlled-collapse chip connection (C4) bumps.

Coupling the segmented interposers to the organic substrate may include bonding the second interposers to an upper surface of the organic substate.

Bonding the second interposers to the upper surface of the organic substrate may utilize controlled-collapse chip connection (C4) bumps.

Bonding the second interposers to the upper surface of the organic substrate may utilize micro-bumps.

Coupling the segmented interposers together with the second interposers may include bonding the second interposers to upper surfaces of the segmented interposers with micro-bumps.

The second interposers may have a height substantially equal to a height of the computer chips.

The computer chips may be high-bandwidth memory (HBM) devices.

This summary is provided to introduce a selection of concepts that are further described below in the detailed description. This summary is not intended to identify key or essential features of the claimed subject matter, nor is it intended to be used in limiting the scope of the claimed subject matter. One or more of the described features may be combined with one or more other described features to provide a workable device.

### ADVANTAGEOUS EFFECT OF THE INVENTION

Embodiments of the present disclosure provide segmented silicon interposers for three-dimensional stacked chips with improved performance by each supporting a single computer chip.

Specifically, by providing computer chips on separate segmented silicon interposers, warpage of the segmented silicon interposers at high temperatures is reduced.

### BRIEF DESCRIPTION OF THE DRAWINGS

The patent or application file contains at least one drawing executed in color.

The features and advantages of embodiments of the present disclosure will be better understood by reference to the following detailed description when considered in conjunction with the accompanying figures. In the figures, like reference numerals are used throughout the figures to reference like features and components. The figures are not necessarily drawn to scale.
FIGS. 1A-1C are a perspective view, a side view, and a top view, respectively, of a related art device including a plurality of chips on a single silicon interposer;
FIG. 1D is a heat map depicting the warpage of the related art interposer at a temperature of approximately 250 °C;
FIGS. 2A-2B are a perspective view and a side view, respectively, of a device including a plurality of segmented interposers according to one embodiment of the present disclosure;
FIG. 3 is a side view of a device including a plurality of segmented interposers according to another embodiment of the present disclosure;
FIG. 4 is a side view of a device including a plurality of segmented interposers according to a further embodiment of the present disclosure;
FIG. 5 is a side view of a device including a plurality of segmented interposers according to another embodiment of the present disclosure;
FIG. 6 is a graph comparing the warpage of a segmented interposer according to one embodiment of the present disclosure to the warpage of related art interposers; and
FIG. 7 is a flowchart illustrating tasks of a method of manufacturing a device according to one embodiment of the present disclosure.

### DETAILED DESCRIPTION

The present disclosure relates to various embodiments of segmented silicon interposers for three-dimensional (3D) chips (e.g., system-on-a-chip (SoC)). In one or more embodiments, each segmented silicon interposer may support a single computer chip (e.g., a single high-bandwidth memory (HBM) device), which is configured to reduce the warpage of the interposers at high temperature compared to a related art silicon interposer that supports multiple chips (e.g., multiple HBM devices). Additionally, in one or more embodiments, because the computer chips are provided on separate segmented silicon interposers to reduce the warpage at high temperatures, an epoxy molding compound (EMC) layer may not be provided on the computer chips, unlike the related art device depicted in FIGS. 1A-1C that utilize EMC layers on the HBM chips to reduce the coefficient of thermal expansion (CTE) of the HBM chips in an effort to reduce warpage of the interposer.

Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof may not be repeated.

In the drawings, the relative sizes of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present invention.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present invention. As used herein, the singular forms "a" and "an" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively. Also, the term "exemplary" is intended to refer to an example or illustration.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

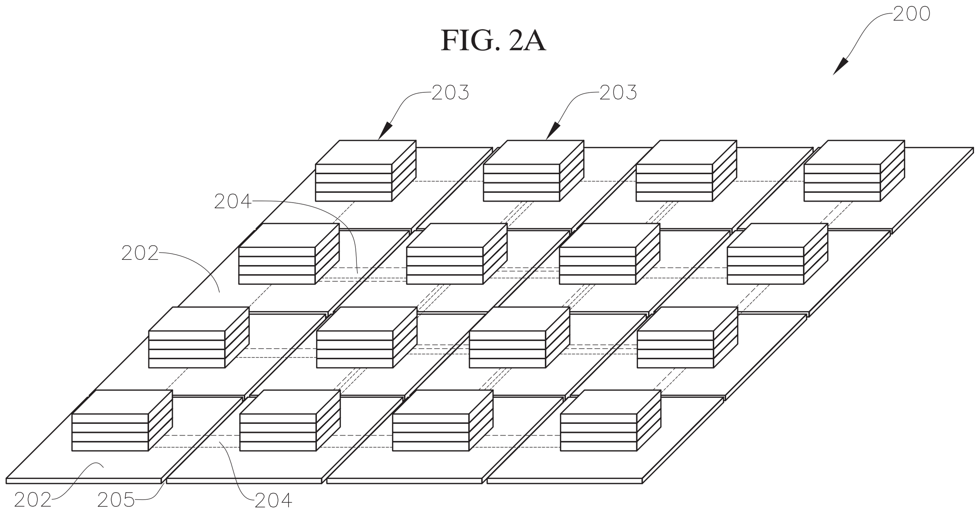

FIGS. 2A-2B depict a device **200** (e.g., a system-on-a-chip (SoC)) according to one embodiment of the present disclosure including an organic substrate **201,** a plurality of segmented silicon interposers **202** coupled to the organic substrate **201,** a plurality of computer chips **203** (e.g., high-bandwidth memory (HBM) chips) supported on the plurality of segmented silicon interposers **202,** and a plurality of second silicon interposers **204** coupling adjacent segmented silicon interposers **202** together.

In the illustrated embodiment, each of the second silicon interposers **204** extends across a gap **205** between adjacent segmented silicon interposers **202** (e.g., each of the second silicon interposers **204** bridges the gap **205** between adjacent segmented silicon interposers **202).** Additionally, in the illustrated embodiment, the second silicon interposers **204** are between the segmented silicon interposers **202** and the organic substrate **201.** In the illustrated embodiment, the second silicon interposers **204** are coupled to lower surfaces **206** of the segmented silicon interposers **202** with a first set of micro-bumps **207** and are coupled to an upper surface **208** of the organic substrate **201** with a second set of micro-bumps **209.** Additionally, in one or more embodiments, each second silicon interposer **204** may include redistribution layers (RDLs) (i.e., copper metal interconnects) to electrically connect the computer chips (e.g., the HBMs) 203 to each other and/or to the organic substrate **201.**

In the illustrated embodiment, the segmented silicon interposers **202** are coupled directly to the upper surface **208** of the organic substrate **201** with a plurality of controlled-collapse chip connection (C4) bumps **210.** Additionally, in the illustrated embodiment, a plurality of solder balls **211** are provided on a lower surface **212** of the organic substrate **201** for attaching the device **200** to other components.

In one or more embodiments, each computer chip (e.g., HBM chip) **203** is coupled to an upper surface **213** of one of the segmented silicon interposers **202** with micro-bumps **214.** In the illustrated embodiment, each segmented silicon interposer **202** supports a single computer chip (e.g., HBM chip) **203.** Accordingly, in one or more embodiments, the number of segmented silicon interposers **202** is equal to the number of computer chips (e.g., HBM chips) **203.** As described in more detail below, providing a single computer chip (e.g., HBM chip) **203** on each segmented silicon interposer **202** is configured to reduce the warpage of the segmented silicon interposers **202** compared to a single silicon interposer supporting all of the computer chips (e.g., HBM chips) **203.** Moreover, in one or more embodiments, because the computer chips (e.g., HBM chips) **203** are provided on separate segmented silicon interposers **202** to reduce the warpage at high temperatures, an epoxy molding compound (EMC) layer may not be provided on the computer chips (e.g., HBM chips) **203,** unlike the related art device depicted in FIGS. 1A-1C that utilize EMC layers on the HBM chips to reduce the coefficient of thermal expansion (CTE) of the HBM chips in an effort to reduce warpage of the interposer.

In one or more embodiments, the device **200** may also include a stiffener and/or a top metal plate configured to increase the rigidity and reliability of the device **200.**

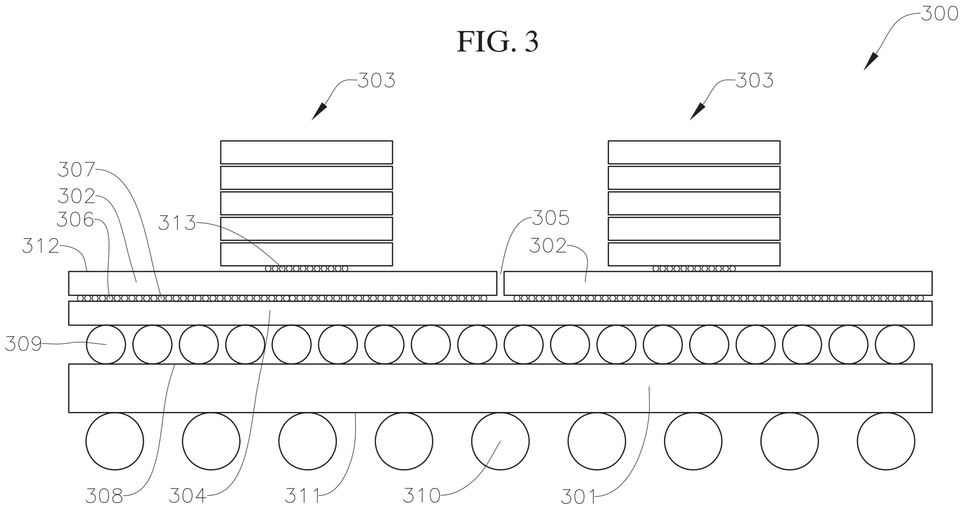

FIG. 3 depicts a device **300** according to another embodiment of the present disclosure. In the illustrated embodiment, the device **300** includes an organic substrate **301,** a plurality of segmented silicon interposers **302** coupled to the organic substrate **301,** a plurality of computer chips **303** (e.g., high-bandwidth memory (HBM) chips) supported on the plurality of segmented silicon interposers **302,** and a plurality of second silicon interposers **304** coupling adjacent segmented silicon interposers **302** together.

In the illustrated embodiment, each of the second silicon interposers **304** extends across a gap **305** between adjacent segmented silicon interposers **302** (e.g., each of the second silicon interposers **304** bridges the gap **305** between adjacent segmented silicon interposers **302).** Additionally, in the illustrated embodiment, the second silicon interposers **304** are between the segmented silicon interposers **302** and the organic substrate **301.** In the illustrated embodiment, second silicon interposers **304** are coupled to lower surfaces **306** of the segmented silicon interposers **302** with a plurality of micro-bumps **307** and are coupled to an upper surface **308** of the organic substrate **301** with a plurality of controlled-collapse chip connection (C4) bumps **309.** Additionally, in one or more embodiments, each second silicon interposer **304** may include redistribution layers (RDLs) (i.e., copper metal interconnects) to electrically connect the computer chips (e.g., HBMs) **303** to each other and/or to the organic substrate **301.**

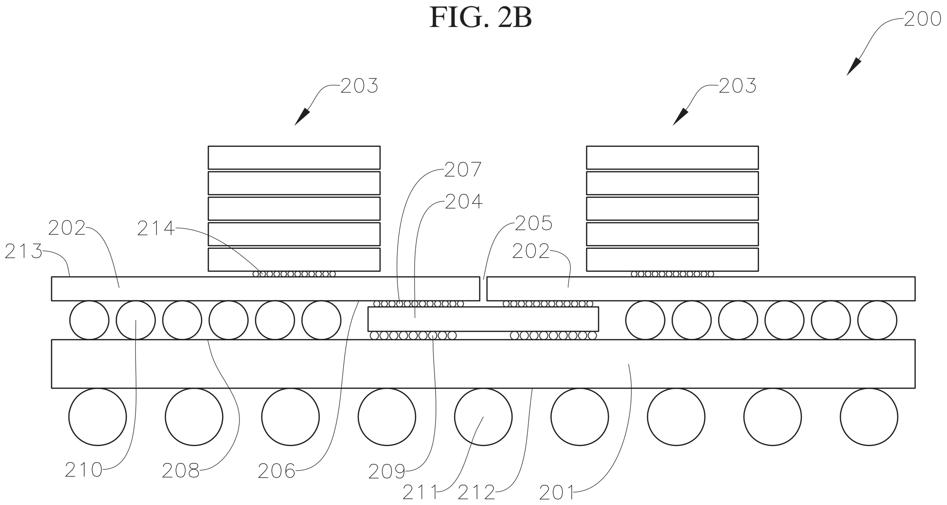

Additionally, in the illustrated embodiment, the size of the second silicon interposer **304** is equal (or substantially equal) to a combined size of the plurality of segmented silicon interposers **302** (e.g., the width of the second silicon interposer **304** is substantially equal to a combined width of the plurality of segmented silicon interposers **302,** and the length of the second silicon interposer **304** is substantially equal to a combined length of the plurality of segmented silicon interposers **302).** Accordingly, in the illustrated embodiment, unlike the embodiment illustrated in FIG. 2, the segmented silicon interposers **302** are indirectly coupled to the organic substrate **301** via the second silicon interposers **304.** Additionally, in the illustrated embodiment, a plurality of solder balls **310** are provided on a lower surface **311** of the organic substrate 301 for attaching the device **300** to other components.

In one or more embodiments, each computer chip (e.g., HBM chip) **303** is coupled to an upper surface **312** of one of the segmented silicon interposers **302** with micro-bumps **313.** In the illustrated embodiment, each segmented silicon interposer **302** supports a single computer chip (e.g., HBM chip) **303.** Accordingly, in one or more embodiments, the number of segmented silicon interposers **302** is equal to the number of computer chips (e.g., HBM chips) **303.** As described in more detail below, providing a single computer chip (e.g., HBM chip) **303** on each segmented silicon interposer **302** is configured to reduce the warpage of the segmented silicon interposers **302** compared to a single silicon interposer supporting all of the computer chips (e.g., HBM chips) **303.** Moreover, in one or more embodiments, because the computer chips (e.g., HBM chips) **303** are provided on separate segmented silicon interposers 302 to reduce the warpage at high temperatures, an epoxy molding compound (EMC) layer may not be provided on the computer chips (e.g., HBM chips) **303,** unlike the related art device depicted in FIGS. 1A-1C that utilize EMC layers on the HBM chips to reduce the coefficient of thermal expansion (CTE) of the HBM chips in an effort to reduce warpage of the interposer.

In one or more embodiments, the device **300** may also include a stiffener and/or a top metal plate configured to increase the rigidity and reliability of the device **300.**

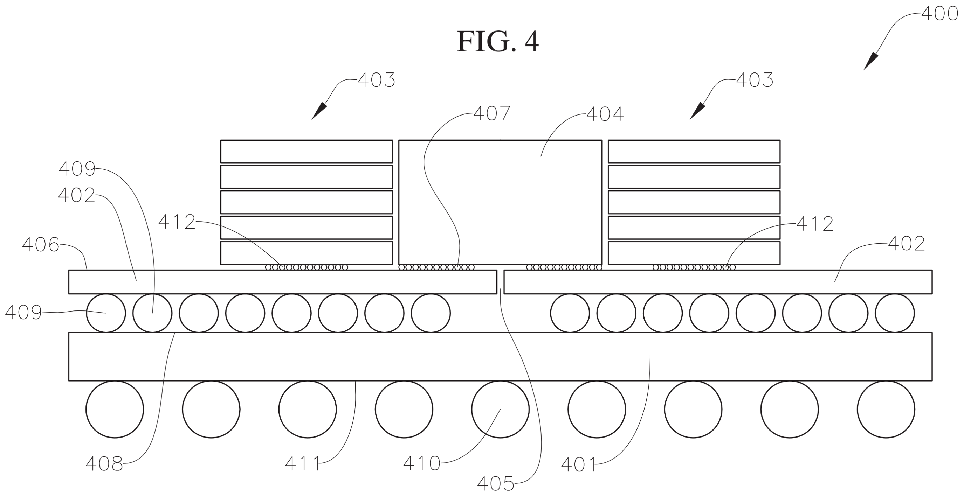

FIG. 4 depicts a device **400** according to one embodiment of the present disclosure including an organic substrate **401,** a plurality of segmented silicon interposers **402** coupled to the organic substrate **401,** a plurality of computer chips **403** (e.g., high-bandwidth memory (HBM) chips) supported on the plurality of segmented silicon interposers **402,** and a plurality of second silicon interposers **404** coupling adjacent segmented silicon interposers **402** together.

In the illustrated embodiment, each of the second silicon interposers **404** extends across a gap **405** between adjacent segmented silicon interposers **402** (e.g., each of the second silicon interposers **404** bridges a gap **405** between adjacent segmented silicon interposers **402).** Additionally, in the illustrated embodiment, the second silicon interposers **404** are supported on the segmented silicon interposers **402** such that the segmented silicon interposers **402** are between the second silicon interposers **404** and the organic substrate **401.** In one or more embodiments, the height of the second silicon interposers **404** may be equal (or substantially equal) to the height of the computer chips (e.g., HBM devices) **403** (e.g., the second silicon interposers **404** may be co-planar or substantially co-planar with the computer chips **403).** In the illustrated embodiment, the second silicon interposers **404** are coupled to upper surfaces **406** of the segmented silicon interposers **402** with micro-bumps **407.** Additionally, in one or more embodiments, each second silicon interposer **404** may include redistribution layers (RDLs) (i.e., copper metal interconnects) to electrically connect the computer chips (e.g., HBMs) **403** to each other.

In the illustrated embodiment, the segmented silicon interposers **402** are coupled directly to an upper surface **408** of the organic substrate **401** with a plurality of controlled-collapse chip connection (C4) bumps **409.** Additionally, in the illustrated embodiment, a plurality of solder balls **410** are provided on a lower surface **411** of the organic substrate **401** for attaching the device **400** to other components.

In one or more embodiments, each computer chip (e.g., HBM chip) **403** is coupled to the upper surface **406** of one of the segmented silicon interposers **402** with micro-bumps **412.** In the illustrated embodiment, each segmented silicon interposer **402** supports a single computer chip (e.g., HBM chip) **403.** Accordingly, in one or more embodiments, the number of segmented silicon interposers **402** is equal to the number of computer chips (e.g., HBM chips) **403.** As described in more detail below, providing a single computer chip (e.g., HBM chip) **403** on each segmented silicon interposer **402** is configured to reduce the warpage of the segmented silicon interposers **402** compared to a single silicon interposer supporting all of the computer chips (e.g., HBM chips) **403.** Moreover, in one or more embodiments, because the computer chips (e.g., HBM chips) **403** are provided on separate segmented silicon interposers 402 to reduce the warpage at high temperatures, an epoxy molding compound (EMC) layer may not be provided on the HBM chips **403,** unlike the related art device depicted in FIGS. 1A-1C that utilize EMC layers on the HBM chips to reduce the coefficient of thermal expansion (CTE) of the HBM chips in an effort to reduce warpage of the interposer. Furthermore, the second silicon interposers **404** function as dummy silicon for heat reduction.

In one or more embodiments, the device **400** may also include a stiffener and/or a top metal plate configured to increase the rigidity and reliability of the device **400.**

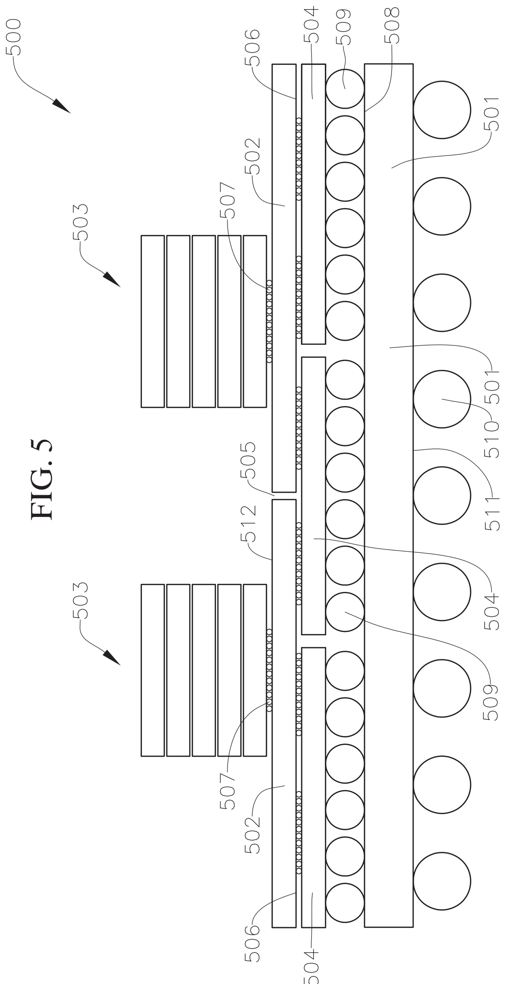

FIG. 5 depicts a device **500** according to one embodiment of the present disclosure including an organic substrate **501,** a plurality of segmented silicon interposers **502** coupled to the organic substrate **501,** a plurality of computer chips **503** (e.g., high-bandwidth memory (HBM) chips) supported on the plurality of segmented silicon interposers **502,** and a plurality of second silicon interposers **504** coupling adjacent segmented silicon interposers **502** together and coupling the segmented silicon interposers **502** to the organic substrate **501.**

In the illustrated embodiment, some of the second silicon interposers **504** extend across a gap **505** between adjacent segmented silicon interposers **502** (e.g., some of the second silicon interposers **504** bridge a gap **505** between adjacent segmented silicon interposers **502).** The remaining second silicon interposers **504** do not extend across the gaps **505** between the adjacent segmented silicon interposer **502.** Additionally, in the illustrated embodiment, the second silicon interposers **504** are between the segmented silicon interposers **502** and the organic substrate **501.** In the illustrated embodiment, the second silicon interposers **504** are coupled to lower surfaces **506** of the segmented silicon interposers **502** with a plurality of micro-bumps **507** and are coupled to an upper surface **508** of the organic substrate **501** with a plurality of controlled-collapse chip connection (C4) bumps **509.** Accordingly, in the illustrated embodiment, the segmented silicon interposers **502** are indirectly coupled to the organic substrate **501** via the second silicon interposers **504.** Additionally, in the illustrated embodiment, a plurality of solder balls **510** are provided on a lower surface **511** of the organic substrate **501** for attaching the device **500** to other components. Additionally, in one or more embodiments, each second silicon interposer **504** may include redistribution layers (RDLs) (i.e., copper metal interconnects) to electrically connect the computer chips (e.g., HBMs) **503** to each other and/or to the organic substrate **501.**

In one or more embodiments, each HBM chip **503** is coupled to an upper surface **512** of one of the segmented silicon interposers **502** with micro-bumps **513.** In the illustrated embodiment, each segmented silicon interposer **502** supports a single computer chip (e.g., HBM chip) **503.** Accordingly, in one or more embodiments, the number of segmented silicon interposers **502** is equal to the number of computer chips (e.g., HBM chips) **503.** As described in more detail below, providing a single computer chip (e.g., HBM chip) **503** on each segmented silicon interposer **502** is configured to reduce the warpage of the segmented silicon interposers **502** compared to a single silicon interposer supporting all of the computer chips (e.g., HBM chips) **503.** Moreover, in one or more embodiments, because the computer chips (e.g., HBM chips) **503** are provided on separate segmented silicon interposers to reduce the warpage at high temperatures, an epoxy molding compound (EMC) layer may not be provided on the computer chips (e.g., HBM chips) **503,** unlike the related art device depicted in FIGS. 1A-1C that utilize EMC layers on the HBM chips to reduce the coefficient of thermal expansion (CTE) of the HBM chips in an effort to reduce warpage of the interposer.

In one or more embodiments, the device **500** may also include a stiffener and/or a top metal plate configured to increase the rigidity and reliability of the device **500.**

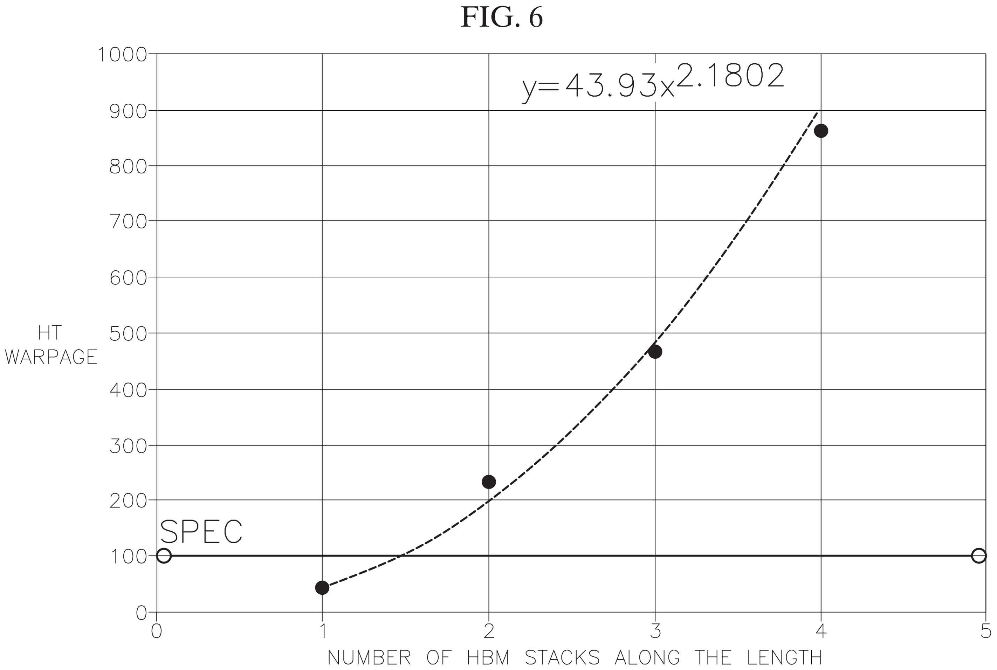

FIG. 6 is a graph comparing the warpage of a segmented interposer according to one embodiment of the present disclosure to the warpage of related art interposers. As illustrated in FIG. 6, the device according to the present disclosure exhibits warpage at high temperature of approximately only 100 µm regardless of the number of computer chips (e.g., HBM devices), whereas related art devices exhibit higher warpage that increases as the number of computer chips (e.g., HBM devices) increases. For instance, FIG. 6 depicts that a related art device having two computer chips (e.g., HBM devices) along the length of a single silicon interposer (e.g., a 2x2 grid of computer chips on a single silicon interposer) exhibits warpage of approximately 240 µm at high temperature, a related art device having three computer chips (e.g., HBM devices) along the length of a single silicon interposer (e.g., a 3x3 grid of computer chips on a single silicon interposer) exhibits warpage of approximately 460 µm at high temperature, and a related art device having four computer chips (e.g., HBM devices) along the length of a single silicon interposer (e.g., a 4x4 grid of computer chips on a single silicon interposer) exhibits warpage of approximately 860 µm at high temperature.

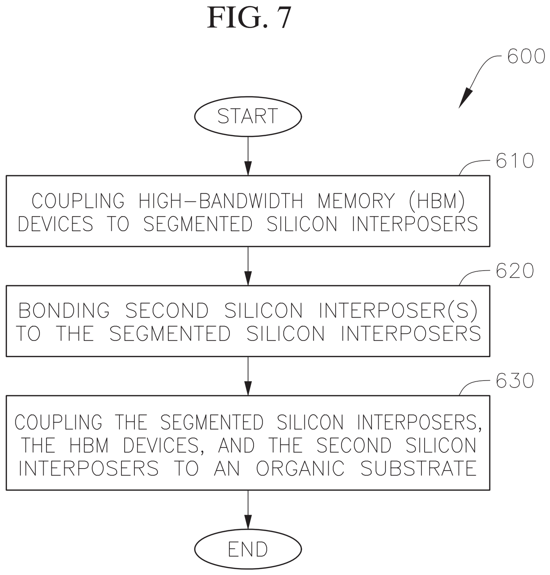

FIG. 7 is a flowchart illustrating tasks of a method **600** of manufacturing a device according to one embodiment of the present disclosure. In the illustrated embodiment, the method **600** includes a task **610** of coupling a plurality of computer chips (e.g., high-bandwidth memory (HBM) devices) to a plurality of segmented silicon interposers. In one or more embodiments, in task **610,** each computer chip (e.g., HBM device) is coupled to a different segmented silicon interposer (i.e., the computer chips are provided on separate, individual silicon interposers such that each segmented silicon interposer supports one computer chip). In one or more embodiments, the task **610** includes bonding the computer chips (e.g., HBM devices) to the segmented silicon interposers with micro-bumps.

In the illustrated embodiment, the method **600** also includes a task **620** of coupling the segmented silicon interposers together. In one embodiment, the task **620** includes bonding at least one second silicon interposer to the segmented silicon interposers. In one or more embodiments, the task **620** includes bonding the second silicon interposer(s) to the segmented silicon interposers with micro-bumps. Additionally, in one or more embodiments, in task **620,** the second silicon interposer(s) may be coupled to upper surfaces of the segmented silicon interposers or to lower surfaces of the segmented silicon interposers. Furthermore, in one or more embodiments, in task **620,** at least some of the second silicon interposers extend across gaps (i.e., bridge gaps) between adjacent segmented silicon interposers. In one or more embodiments, following task **620,** the second silicon interposer(s) may be coupled to lower surfaces of the segmented silicon interposers as shown in the embodiment of FIGS. 2A-2B, the embodiment of FIG. 3, or the embodiment of 5. In one or more embodiments, following task 620, the second silicon interposers may be coupled to upper surfaces of the segmented silicon interposers as shown in the embodiment of FIG. 4.

In the illustrated embodiment, the method **600** also includes a task **630** of coupling the segmented silicon interposers, the computer chips (e.g., HBM devices) supported on segmented silicon interposer, and the second silicon interposer(s) to an organic substrate. In one or more embodiments in which the second silicon interposer(s) is/are coupled to the lower surfaces of the segmented silicon interposers, the task **630** may include bonding the second silicon interposer(s) to an upper surface of the organic substrate with micro-bumps and bonding the segmented silicon interposers to the upper surface of the organic substrate with controlled-collapse chip connection (C4) bumps. In one or more embodiments in which the second silicon interposer(s) is/are coupled to the lower surfaces of the segmented silicon interposers, the task **630** may include bonding the second silicon interposer(s) to the upper surface of the organic substrate with C4 bumps and the segmented silicon interposers may be indirectly coupled to the organic substrate via the second silicon interposer(s). In one or more embodiments in which the second silicon interposer(s) is/are coupled to the upper surfaces of the segmented silicon interposers, the task **630** may include bonding the segmented silicon interposers directly to the upper surface of the organic substrate with C4 bumps.

The device manufactured according to the method **600** is configured to exhibit reduced warpage at high temperatures compared to a related art device in which a single silicon interposer supports multiple computer chips (e.g., HBM devices) that have different coefficients of thermal expansion (CTE).

While this invention has been described in detail with particular references to embodiments thereof, the embodiments described herein are not intended to be exhaustive or to limit the scope of the invention to the exact forms disclosed. Persons skilled in the art and technology to which this invention pertains will appreciate that alterations and changes in the described structures and methods of assembly and operation can be practiced without meaningfully departing from the scope of this invention as defined by the appended claims.

## Claims

1. A system-on-a-chip, SoC, comprising:
a plurality of segmented interposers;
a plurality of computer chips, one computer chip of the plurality of computer chips being on each segmented interposer of the plurality of segmented interposers;
a plurality of second interposers connecting the plurality of segmented interposers together, at least some of the plurality of second interposers extending across a gap between adjacent segmented interposers of the plurality of segmented interposers; and
an organic substrate coupled to each of the plurality of segmented interposers.

2. The SoC of claim 1, wherein the plurality of second interposers is between the plurality of segmented interposers and the organic substrate.

3. The SoC of claim 2, wherein the plurality of second interposers is coupled to lower surfaces of the plurality of segmented interposers with micro-bumps.

4. The SoC of claim 2 or 3, wherein the plurality of second interposers is coupled to an upper surface of the organic substrate with micro-bumps.

5. The SoC of claim 2 or 3, wherein the plurality of second interposers is coupled to an upper surface of the organic substrate with controlled-collapse chip connection, C4, bumps.

6. The SoC of claim 1, wherein the plurality of second interposers is on upper surfaces of the plurality of segmented interposers.

7. The SoC of claim 6, wherein the plurality of second interposers has a height substantially equal to a height of the plurality of computer chips.

8. The SoC of claim 6 or 7, wherein the plurality of second interposers is coupled to upper surfaces of the plurality of segmented interposers with micro-bumps.

9. The SoC of any one of claims 1 to 8, wherein some of the plurality of second interposers do not extend across the gap between adjacent segmented interposers.

10. The SoC of any one of claims 1 to 9, wherein the plurality of computer chips comprises a plurality of high-bandwidth memory, HBM, devices.

11. A method of manufacturing a system-on-a-chip, SoC, the method comprising:
coupling a plurality of computer chips to a plurality of segmented interposers, wherein one computer chip of the plurality of computer chips is on each segmented interposer of the plurality of segmented interposers;
coupling the plurality of segmented interposers together with a plurality of second interposers; and
coupling the plurality of segmented interposers to an organic substrate.

12. The method of claim 11, wherein the coupling the plurality of segmented interposers together with the plurality of second interposers comprises bonding the plurality of second interposers to lower surfaces of the plurality of segmented interposers with micro-bumps.

13. The method of claim 11, wherein the coupling the plurality of segmented interposers together with the plurality of second interposers comprises bonding the plurality of second interposers to upper surfaces of the plurality of segmented interposers with micro-bumps.

14. The method of claim 11 or 12, wherein the coupling the plurality of segmented interposers to the organic substrate comprises bonding the plurality of segmented interposers directly to an upper surface of the organic substate with controlled-collapse chip connection, C4, bumps.

15. The method of claim 11 or 12, wherein the coupling the plurality of segmented interposers to the organic substrate comprises bonding the plurality of second interposers to an upper surface of the organic substate.
